# EUROPÄISCHE PATENTSCHRIFT

(11) **EP 3 454 071 B1**
(45) Veröffentlichungstag und Bekanntmachung des Hinweises auf die Patenterteilung: **27.10.2021**
(21) Anmeldenummer: 17189644.2
(22) Anmeldetag: 06.09.2017
(51) Int. Cl.: G01R 33/54, G01R 33/34, G01R 33/385

(54) **VERFAHREN ZUR ÜBERWACHUNG DER FUNKTION EINES KÜHLSYSTEMS EINER MAGNETRESONANZEINRICHTUNG, MAGNETRESONANZEINRICHTUNG, COMPUTERPROGRAMM UND ELEKTRONISCH LESBARER DATENTRÄGER**
METHOD FOR MONITORING THE FUNCTION OF A COOLING SYSTEM OF A MAGNETIC RESONANCE DEVICE, MAGNETIC RESONANCE DEVICE, COMPUTER PROGRAM AND ELECTRONICALLY READABLE DATA CARRIER
PROCÉDÉ DE SURVEILLANCE DE LA FONCTION D'UN SYSTÈME DE REFROIDISSEMENT D'UN DISPOSITIF DE RÉSONANCE MAGNÉTIQUE, DISPOSITIF DE RÉSONANCE MAGNÉTIQUE, PROGRAMME INFORMATIQUE ET SUPPORT DE DONNÉES LISIBLE DE MANIÈRE ÉLECTRONIQUE

(43) Veröffentlichungstag der Anmeldung: 13.03.2019
(73) Patentinhaber: Siemens Healthcare GmbH, 91052 Erlangen (DE)
(72) Erfinder: Biber, Stephan, 91056 Erlangen (DE)

(56) Entgegenhaltungen:
- DE-U1-202017 001 501
- US-A1- 2002 156 595
- US-A1- 2006 225 433
- US-A1- 2010 085 053

## Beschreibung

Die Erfindung betrifft ein Verfahren zur Überwachung der Funktion eines Kühlsystems einer Magnetresonanzeinrichtung, die mehrere durch das Kühlsystem zu kühlende Komponenten und den Komponenten zumindest teilweise zuordenbare Temperatursensoren aufweist. Daneben betrifft die Erfindung eine Magnetresonanzeinrichtung, ein Computerprogramm und einen elektronisch lesbaren Datenträger.

Magnetresonanzeinrichtungen stellen komplexe Systeme dar, in denen - neben gegebenenfalls einem supraleitenden Magneten - eine Vielzahl von Komponenten Abwärme erzeugen, welche durch ein entsprechendes Kühlsystem abzuführen ist. Zu kühlende Komponenten umfassen dabei hauptsächlich die Gradientenspulenanordnung (GC), die Gradientenverstärker (GPA), den Kompressor (MREF) zum Antrieb des Kaltkopfes zum Kühlen des supraleitenden Magneten sowie die Hochfrequenz-Leistungsverstärker (RFPA). Auch weitere, insbesondere kleinere Komponenten, beispielsweise ein Bild- und Steuerrechner, Transformatoren und Netzteile zur Erzeugung der nötigen Spannungen können durch ein derartiges Kühlsystem, welches üblicherweise ein flüssiges Kühlmittel nutzt, gekühlt werden.

Kühlsysteme des Standes der Technik werden mit einer Vielzahl von Sensoren zur Überwachung des Durchflusses des Kühlmittels und der Temperaturen bestückt. Die Sensoren können durch eine Steuereinheit des Kühlsystems ausgelesen werden und mittels eines standardisierten Bussystems (beispielsweise CAN, SPI, I2C) an eine Steuereinrichtung der Magnetresonanzeinrichtung übergeben werden. Die so der Magnetresonanzeinrichtung verfügbar gemachten Sensordaten können zur Überwachung des Kühlsystems vor Ort, zur Fernwartung oder auch zur Präventivwartung ("preventive maintenance") genutzt werden, indem die Sensordaten oder daraus abgeleitete Metadaten an eine zentrale Recheneinrichtung außerhalb der Magnetresonanzeinrichtung übermittelt werden.

Problematisch bei diesen bekannten Überwachungsmöglichkeiten sind die hohen Kosten und der hohe Aufwand für die Sensorik und die Elektronik des Kühlsystems.

Um hierbei eine Verbesserung zu erreichen, wurde in einem Artikel von Stephan Biber, "Nutzung von verteilter Sensorik zur Überwachung des Kühlsystems von Magnetresonanztomographen", 2016, DOI: 10.18169/PAPDEOTT005284, vorgeschlagen, auf die kühlsystemseitige Sensorik zumindest weitgehend zu verzichten und stattdessen die Temperaturüberwachung des Kühlsystems wenigstens teilweise durch die Temperaturüberwachung der an das Kühlsystem angeschlossenen Komponenten zu ersetzen. Dabei wird ausgenutzt, dass die meisten Komponenten ohnehin eine eigene Temperaturüberwachung besitzen. Auf diese Weise können Überhitzungen bei Komponenten detektiert werden, wobei jedoch vorgeschlagen wird, um hinreichende Informationen über den Status des Kühlsystems zu erhalten und Fehlerursachen zielgerecht detektieren zu können, dennoch weiter das Kühlsystem mit eigenen, kostenaufwendigen, zusätzlichen Sensoren zu versehen. Mithin lässt die vorgeschlagene Variante lediglich eine vereinfachte Überhitzungsüberwachung zu, während zu konkreten Aussagen über Fehler bzw. Einschränkungen des Kühlsystems weiterhin teure und aufwendige Sensorik sowie Elektronik vorhanden sein muss.

Aus dem Dokument US 2006/0225433 A1 ist ein weiteres Verfahren zur Überwachung der Funktion eines Kühlsystems einer Magnetresonanzeinrichtung bekannt.

Der Erfindung liegt daher die Aufgabe zugrunde, eine möglichst einfach und kostengünstig zu realisierende, verlässliche Möglichkeit zur Überwachung eines Kühlsystems auch hinsichtlich konkreter Fehlerfälle und/oder Einschränkungen des Kühlsystems anzugeben, insbesondere im Hinblick auf eine frühzeitige Problemerkennung und/oder präventive Wartung.

Zur Lösung dieser Aufgabe werden erfindungsgemäß ein Verfahren, eine Magnetresonanzeinrichtung, ein Computerprogramm und ein elektronisch lesbarer Datenträger gemäß den unabhängigen Ansprüchen 1 und 18-20 bereitgestellt. Vorteilhafte Ausgestaltungen ergeben sich aus den Unteransprüchen.

In einem erfindungsgemäßen Verfahren ist zur Überwachung der Funktion des Kühlsystems bezüglich wenigstens einer der Komponenten, in die ein Leistungseintrag erfolgt, mithin vorgesehen, dass
- eine Starttemperatur der Komponente unmittelbar vor Beginn des Leistungseintrags mittels wenigstens eines der Komponente zugeordneten Temperatursensors ermittelt wird,
- aus der Starttemperatur eine eine Vergleichstemperaturänderung durch den Leistungseintrag beschreibende Vergleichsgröße ermittelt wird,
- eine durch den Leistungseintrag tatsächlich auftretende Temperaturänderung beschreibende Messgröße mittels des wenigstens einen der Komponente zugeordneten Temperatursensors gemessen wird und
- die Messgröße mit der Vergleichsgröße verglichen wird, wobei bei Erfüllung eines wenigstens das aktuelle Vergleichsergebnis auswertenden Maßnahmenkriteriums eine dem Maßnahmenkriterium zugeordnete Maßnahme durchgeführt wird und/oder das Vergleichsergebnis durch Abspeicherung für eine spätere Auswertung protokolliert wird.

In einer vorteilhaften Weiterbildung liegen den zeitbezogenen Leistungseintrag in die betreffende Komponente beschreibende Leistungsdaten vor, wobei aus der Starttemperatur und den Leistungsdaten wenigstens eine eine Vergleichstemperaturänderung durch den Leistungseintrag beschreibende Vergleichsgröße ermittelt wird.

Die Zuordnung eines Temperatursensors zu einer Komponente ist hierbei so zu verstehen, dass der jeweilige Temperatursensor Messdaten liefert, die die Temperatur der Komponente beschreiben bzw. aus denen die Temperatur der Komponente abgeleitet werden kann. Dabei können selbstverständlich auch Ausgestaltungen gegeben sein, bei denen der Temperatursensor (oder sogar mehrere Temperatursensoren) unmittelbar an der Komponente angeordnet sind.

Entgegen dem eingangs zuerst genannten Stand der Technik schlägt die Erfindung mithin keine reine Temperaturüberwachung, insbesondere im Hinblick auf eine Überhitzung, vor, sondern eine Überwachung der tatsächlich vorhandenen Kühlleistung, indem, bevorzugt leistungsbezogen, überwacht wird, welche Temperaturänderungen, insbesondere Erwärmungen, auftreten. Es ist somit kein reiner "Überhitzungsschutz" vorhanden, sondern es wird der Temperaturgradient analysiert. Besonders bevorzugt wird bei bekannter thermischer Belastung aufgrund der Leistungsdaten Bezug auf eine Vergleichsgröße selber thermischer Belastung an derselben Komponente genommen. Nachdem zudem komponentenbezogen gearbeitet werden kann, ergibt sich eine weitere Verfeinerung der erhaltbaren Information.

Eine Grundidee der vorliegenden Erfindung ist es also, für verschiedene Leistungsdaten und Starttemperaturen Vergleichsgrößen bereitzustellen, die letztlich eine Soll-Kühlleistung bei einem bestimmten Durchfluss des Kühlmittels bzw. bestimmten Kühlwirkungen beschreiben können. Die leistungsbezogene Herangehensweise der vorliegenden Erfindung ermöglicht mithin letztlich einen Rückschluss auf die Durchflussmenge an Kühlmittel durch die jeweilige Komponente. Hierzu sind lediglich Temperatursensoren notwendig, die an den Komponenten einer Magnetresonanzeinrichtung meist ohnehin vorhanden sind, deren Messdaten die Auswirkungen des Leistungseintrags und der Kühlung durch das Kühlsystem beschreiben. Auf diese Weise kann eine aufwendige Durchflusssensorik ersetzt werden durch ohnehin in der Magnetresonanzeinrichtung vorhandene Temperatursensoren und eine erweiterte Auswertung der Messdaten dieser Temperatursensoren mithilfe von auf den Leistungseintrag bezogenen Vergleichsgrößen, welche beispielsweise aus Vergleichsmessungen und/oder thermischen Temperaturänderungsmodellen der Komponenten ermittelt werden können, worauf im Folgenden noch näher eingegangen werden wird. Auf diese Weise wird letztlich ein Rückschluss auf Flusseigenschaften im Kühlsystem ermöglicht.

Insbesondere können auf diese Art und Weise in den Vergleichsergebnissen sich reduzierende bzw. reduzierte Kühlleistungen und somit insbesondere reduzierte Durchflussmengen, bezogen auf bestimmte Komponenten bzw. Kühlzweige des Kühlsystems gezielt detektiert werden und beispielsweise im Hinblick auf eine Fern- und/oder Präventivwartung eingesetzt werden, bevor ein tatsächlicher Fehlerfall auftritt, bzw. eine verlässlichere Identifikation des tatsächlich vorliegenden Fehlers im Fehlerfall erlauben. Dabei könnten die Maßnahmenkriterien insbesondere auf Fehlerfälle abzielen, so dass beispielsweise bei einer zu geringen Kühlleistung als Maßnahmen eine Überhitzung vermeidende Ansteuerungen der Magnetresonanzeinrichtung, insbesondere eine Abschaltung von Komponenten, vorgenommen werden kann und/oder geeignete Warnsignale als Maßnahmen ausgegeben werden können. Eine Auswertung von Vergleichsergebnissen über die Zeit, nachdem diese abgespeichert und somit protokolliert wurden, ist insbesondere hinsichtlich einer Wartung bzw. Vorhersage möglicherweise eintretender Fehlerfälle nützlich. Beispielsweise kann bei einer kontinuierlichen Reduzierung der Kühlleistung und somit voraussichtlich des Durchflusses auf ein langsam zunehmendes Verstopfen bzw. Verschließen einer Kühlleitung geschlossen werden und dergleichen. Ersichtlich bilden die gewonnenen Vergleichsergebnisse eine hervorragende Basis zur Detektion von Fehlerfällen und/oder Minderfunktionen des Kühlsystems an sich sowie zur genaueren Analyse der Ursachen und/oder des Ursprungs der nachlassenden Kühlleistung des Kühlsystems.

Dabei bezieht sich die vorliegende Erfindung nicht auf eine einem supraleitenden Magneten der Magnetresonanzeinrichtung zu dessen Kühlung zugeordnete Kühleinrichtung, sondern auf ein beispielsweise Wasser als Kühlmittel nutzendes Kühlsystem für weitere, Abwärme erzeugende Komponenten der Magnetresonanzeinrichtung. Komponenten können dabei vorzugsweise eine Gradientenspulenanordnung und/oder wenigstens einen Gradientenverstärker und/oder einen Kompressor eines Kaltkopfes zum Kühlen eines supraleitenden Grundfeldmagneten und/oder Hochfrequenz-Leistungsverstärker umfassen. Weitere Komponenten können Recheneinrichtungen und/oder Transformatoren und/oder Netzteile der Magnetresonanzeinrichtung sein.

Eine vorteilhafte Weiterbildung der Erfindung sieht vor, dass für wenigstens eine Komponente wenigstens zwei insbesondere unterschiedlichen Orten an der Komponente zugeordnete Starttemperaturen und jeweilige Messgrößen gemessen werden, wobei aus den Starttemperaturen und den Leistungsdaten gemeinsam jeweils die wenigstens zwei entsprechenden Vergleichsgrößen ermittelt werden. Werden mehrere Starttemperaturen an einer der Komponenten betrachtet, ist eine deutlich genauere Analyse des leistungsbezogenen Kühlverhaltens möglich. Beispielsweise kann vorgesehen sein, dass eine Starttemperatur auf einen Eintrittsbereich von Kühlmittel des Kühlsystems in die Komponente und eine weitere Starttemperatur auf einen Austrittsbereich von Kühlmittel des Kühlsystems aus der Komponente bezogen ist. Denkbar ist es mithin beispielsweise, dass eine Eingangstemperatur und eine Ausgangstemperatur an einer Komponente durch Messung ermittelt wird, beispielsweise an einem Leistungsverstärker (RFPA und/oder GPA). Dabei muss nicht zwangsläufig eine Anordnung von mehreren Temperatursensoren an einer durch das Kühlsystem gekühlten Komponente vorliegen, sondern es lassen sich durchaus, insbesondere bei seriell gekühlten Komponenten, gegebenenfalls auch Aussagen aufgrund vorhergehend oder nachfolgend gekühlter Komponenten treffen.

So sieht eine bevorzugte Weiterbildung der Erfindung vor, dass bei einer seriellen Kühlung mehrerer Komponenten, insbesondere entlang eines Kühlzweigs, die auf den Austrittsbereich bezogene Starttemperatur einer Komponente und/oder eine allgemeine Starttemperatur einer aktuell unbenutzten Komponente als auf den Eintrittsbereich bezogene Starttemperatur einer folgenden Komponente und/oder als auf den Austrittsbereich bezogene Starttemperatur einer vorangehenden Komponente verwendet wird. Dabei kann eine allgemeine Starttemperatur einer Komponente als einzige und/oder gemittelte und/oder beliebige Starttemperatur der aktuell ungenutzten Komponente verstanden werden. Es wird mithin die Reduzierung der Sensorenanzahl durch intelligentes Nutzen von Temperatursensoren in Zweigen seriell gekühlter Komponenten vorgeschlagen. Beispielsweise kann bei solchen seriellen Schaltungen von Komponenten der Temperatursensor einer nachfolgenden, gerade unbenutzten Komponente als Temperatursensor für die Ausgangstemperatur der vorangehenden Komponente genutzt werden, wenn diese keinen direkten Temperatursensor im Austrittsbereich besitzt. Umgekehrt kann auch vorgesehen sein, dass die Eingangstemperatur einer nachfolgenden Komponente durch einen einer unbenutzten vorangehenden Komponente zugeordneten Temperatursensor erfasst wird, um so eine Starttemperatur bzw. Messgröße für den Eintrittsbereich zu ermitteln.

Auswertungsvorgänge können sich dabei auf unterschiedliche, mit dem Leistungseintrag im Zusammenhang stehende Zeiträume beziehen. So kann vorgesehen sein, dass sich die Temperaturänderung auf wenigstens einen Zeitraum bezieht, wobei als Zeiträume die Dauer des Leistungseintrags und/oder eine dem Leistungseintrag folgende Nachkühlungsphase verwendet werden. Mithin kann beispielsweise eine Temperaturänderung, insbesondere also eine Erwärmung, während des Leistungseintrags selber gemessen und betrachtet werden, so dass hier die Erwärmung durch den Leistungseintrag und der parallel bereits stattfindende Wärmeabtransport durch das Kühlmittel vermessen werden. Zweckmäßig kann es jedoch auch sein, unmittelbar an den Leistungseintrag anschließende Nachkühlungsphasen als Zeitraum zu verwenden, so dass hier lediglich der Abtransport der durch den Leistungseintrag eingetragenen Wärme vermessen wird, mithin insbesondere die Möglichkeit zu einer direkten Kühlleistungsmessung besteht. In diesem Fall betrifft die Temperaturänderung mithin (bei Funktion des Kühlsystems) eine Abkühlung.

Im Rahmen der vorliegenden Erfindung sind grundsätzlich verschiedene Klassen von Vergleichsgrößen nutzbar und verwendbar, die selbstverständlich auch kumulativ eingesetzt werden können, um möglichst weitgehende Informationen hinsichtlich der Funktionsfähigkeit des Kühlsystems zu erhalten.

Eine erste konkrete Ausgestaltung der vorliegenden Erfindung sieht in diesem Zusammenhang vor, dass wenigstens eine der wenigstens einen Vergleichsgröße eine maximal zulässige Erwärmung beschreibt. In diesem Fall wird also eine mindestens zu fordernde Kühlleistung bezogen auf die Leistungsdaten und die Starttemperatur bereitgestellt, wobei beispielsweise ein Maßnahmenkriterium überprüfen kann, ob diese maximal zulässige Temperaturänderung (insbesondere Erwärmung während des Leistungseintrags) unterschritten wird, wobei beispielsweise mehrere Warnstufen vorgesehen sein können, die sich durch unterschiedliche Vergleichsgrößen äußern. Nicht jede dieser Warnstufen muss sich hierbei auf die Ausgabe eines Warnsignals beziehen, sondern es ist durchaus denkbar, dass beispielsweise lediglich weitere Auswertungsvorgänge und/oder Protokollierungsvorgänge angestoßen werden, beispielsweise bei niedrigeren Vergleichsgrößen, während erst bei höheren Vergleichsgrößen tatsächlich Warnsignale ausgegeben werden und/oder die Steuerung der Magnetresonanzeinrichtung angepasst wird. Die Vergleichsgrößen stellen somit eine Art Soll-Anforderung an die Kühlleistung dar.

Zur konkreten Ermittlung der wenigstens einen eine maximal zulässige Erwärmung beschreibenden Vergleichsgröße kann vorgesehen sein, dass die eine maximal zulässige Erwärmung beschreibende Vergleichsgröße wenigstens teilweise rechnerisch mittels eines Temperaturänderungsmodells der Komponente, insbesondere einmalig für einen bestimmten Satz von Leistungsdaten und Starttemperatur, ermittelt wird und/oder aus einem Kennfeld und/oder einer Look-Up-Tabelle abgerufen wird. Mithin kann jeder Komponente ein Temperaturänderungsmodell zugeordnet sein, welches in Form einer Formel und/oder einer Simulation und/oder als bereits im Voraus berechnete Werte, insbesondere in einem Kennfeld und/oder einer Look-Up-Tabelle, vorliegen kann. Das Temperaturänderungsmodell kann beispielsweise die Temperaturerhöhung als Funktion der Zeit T(t) in Abhängigkeit der Starttemperatur T0, der Leistung P und der Dauer des Leistungseintrags Δt als Leistungsdaten beschreiben. Aus den genannten Leistungsdaten (eingetragene Leistung und Dauer des Leistungseintrags) lässt sich mithin auch ein Leistungseintrag pro Zeit ableiten, der ein anderes Beispiel für ein Leistungsdatum darstellt. In Abhängigkeit der Eingangsgrößen des Temperaturänderungsmodells kann eine maximal zulässige Erwärmung durch den Leistungseintrag bestimmt werden, gegebenenfalls auch ein zulässiger Erwärmungsbereich. Eine Überschreitung der maximal zulässigen Erwärmung kann hierbei einen zu niedrigen Durchfluss des Kühlmittels, der zu einem zu hohen Temperaturanstieg führt, zugeordnet werden, das bedeutet allgemein, dass eine Überschreitung einer eine maximal zulässige Erwärmung beschreibenden Vergleichsgröße auf eine reduzierte Durchflussmenge hinweist. Die sich aus dem Temperaturänderungsmodell ergebende maximal zulässige Erwärmung als Vergleichsgröße kann mit entsprechend gemessenen Messgrößen verglichen werden, so dass letztlich eine Flussmessung aufgrund reiner Temperatursensorik erfolgt.

Es sei darauf hingewiesen, dass wenigstens eine der wenigstens einen eine maximal zulässige Erwärmung beschreibenden Vergleichsgröße auch bereits "ab Werk" vorgegeben werden kann, beispielsweise im Hinblick auf eine dort definierte Anforderung an das Kühlsystem und dergleichen.

Eine besonders vorteilhafte Weiterbildung der vorliegenden Erfindung ist ferner gegeben, wenn wenigstens eine der wenigstens einen eine maximal zulässige Erwärmung beschreibenden Vergleichsgröße wenigstens teilweise durch eine Kalibrierungsmessung bei Inbetriebnahme der Magnetresonanzeinrichtung ermittelt wird. Während grundsätzlich auch eine Kalibrierung in einem Werk des Herstellers denkbar ist, wird diese bevorzugt bei der Inbetriebnahme der Magnetresonanzeinrichtung am Einsatzort, also beim sogenannten Tune-Up, durchgeführt. Die letztgenannte Variante bietet den Vorteil, dass die durch unterschiedlichen hydraulischen Abgleich einzelner Teilsysteme sowie durch die Toleranzen der Bauteile innerhalb einer Serie vorliegenden Schwankungen durch die Kalibrierung erfasst werden und somit mit kleineren Toleranzfenstern, insbesondere also strenger definierten Vergleichsgrößen, gearbeitet werden kann, um Fehler oder langsam entstehende Fehler empfindlicher detektieren zu können.

Selbstverständlich können im Übrigen auch Ergebnisse eines Temperaturänderungsmodells und einer Kalibrierung kombiniert werden, entweder zu einer gemeinsamen Vergleichsgröße und/oder zu mehreren Vergleichsgrößen.

Die hier beschriebenen Ausgestaltungen lassen sich selbstverständlich, insbesondere bei Messung in einer Nachkühlungsphase, auf eine entsprechende minimal zulässige Abkühlung übertragen, da in dem Fall, dass kein aktueller Leistungseintrag mehr vorliegt, eine bestimmte Mindestabkühlung durch das Kühlsystem erwartet werden kann.

Es sind auch Ausgestaltungen der vorliegenden Erfindung denkbar, in denen vorgesehen ist, dass, insbesondere zusätzlich zu der eine maximal zulässige Erwärmung und/oder eine minimal zulässige Abkühlung beschreibenden Vergleichsgröße, auch eine eine minimal zulässige Erwärmung bzw. eine eine maximal zulässige Abkühlung beschreibende Vergleichsgröße verwendet wird. Eine derartige Ausgestaltung ist beispielsweise dann nützlich, wenn eine Plausibilisierung hinsichtlich möglicher Messfehler der Temperatursensoren stattfinden soll. Dann wird mithin eine Art Zulässigkeitsbereich definiert.

In einer weiteren konkreten Ausgestaltung der vorliegenden Erfindung kann vorgesehen sein, dass wenigstens eine der wenigstens einen Vergleichsgröße eine in der Vergangenheit gemessene Erwärmung und/oder eine eine funktionsgleiche Komponente der Magnetresonanzeinrichtung betreffende Erwärmung beschreibt. Mithin kann beispielsweise eine zeitliche Entwicklung der Kühleinrichtung beobachtet werden, beispielsweise eine langsam degradierende Kühlleistung und somit vermutlich reduzierte Durchflussmengen, in der die Messgröße, beispielsweise bei Betrachtung der Erwärmung, kontinuierlich zunimmt. Zudem kann auch ein Vergleich mehrerer selbstähnlicher Komponenten genutzt werden, beispielsweise der drei für die jeweiligen Hauptrichtungen vorgesehenen Gradientenverstärker bzw. unterschiedliche Leistungsstufen des Gradientenverstärkers. Diese sollten bei jeweils gleicher elektrischer Last, also bei jeweils gleichem Leistungseintrag, ein ähnliches Temperaturverhalten aufgrund der Wirkung des Kühlsystems zeigen.

In dieser Ausgestaltung ist es besonders vorteilhaft, wenn durch zeitliches Auftragen mehrerer in der Vergangenheit als Messgröße aufgenommener, für eine überwachte Komponente gemessene Temperaturänderungen beschreibender Vergleichsgrößen und der aktuellen Messgröße ein Temperaturänderungsverlauf gebildet wird, der von wenigstens einem Maßnahmenkriterium ausgewertet wird. Durch die Auswertung des zeitlichen Verlaufes findet ein impliziter Vergleich statt, der es ermöglicht, Trends zu bestimmen, beispielsweise ein zunehmendes Verstopfen einer Kühlleitung oder dergleichen. Ein derartiger Temperaturänderungsverlauf wird zweckmäßigerweise auch protokolliert, um beispielsweise durch spätere Auswertungen (manuell oder automatisch) Fehlerursachen bestimmen zu können, Probleme des Kühlsystems feststellen zu können und/oder zukünftige Entwicklungen zu verbessern.

Für den Zeitpunkt der Überwachung des Kühlsystems sind unterschiedliche Ausgestaltungen denkbar, die unterschiedliche Anforderungen stellen können. So kann in einer ersten Ausgestaltung vorgesehen sein, dass die Überwachung während des Bildaufnahmebetriebs der Magnetresonanzeinrichtung erfolgt, wobei ein Leistungsdaten aus aktuellen Betriebsparametern der Magnetresonanzeinrichtung, insbesondere Sequenzparametern einer Magnetresonanzsequenz, ermittelndes Leistungsmodell verwendet wird. Nachdem der Ablauf von Bildaufnahmevorgängen mit der Magnetresonanzeinrichtung in vielen Fällen nicht voraussehbar sein kann bzw. die Zusammenhänge zwischen den Betriebsparametern, insbesondere den Sequenzparametern, und den Leistungseinträgen nicht unbedingt vollständig bzw. hinreichend genau bekannt sind, erfordert eine derartige "inline"-Überwachung eine komplexere Modellierung, nachdem beliebige Betriebsparameter, insbesondere Sequenzparameter, in einen entsprechenden Leistungseintrag umrechenbar sein müssen, insbesondere unter Berücksichtigung der anderen Komponenten. Zweckmäßigerweise können die Temperaturänderungsmodelle und die Leistungsmodelle auch zu einem gemeinsamen Komponentenmodell zusammengefasst werden, so dass dann die Betriebsparameter, insbesondere Sequenzparameter, unmittelbar als Eingangsdaten neben den Starttemperaturen dienen können und die Leistungsdaten implizit ermittelt werden.

Eine andere bevorzugte Ausgestaltung der vorliegenden Erfindung sieht vor, dass die Überwachung in dediziertem, manuell und/oder automatisch begonnenen Überwachungsphasen erfolgt, in denen die Magnetresonanzeinrichtung mit vorbestimmten Betriebsparametern, deren zugehörige Leistungsdaten bekannt sind, betrieben wird. In diesem Fall kann die Messung zur Überwachung der Funktion des Kühlsystems mithin beispielsweise durch manuellen Start dedizierter Servicefunktionen und/oder außerhalb der Magnetresonanzmessung in Zeiträumen, in denen die Magnetresonanzeinrichtung betrieben wird, aber nicht für die Bildaufnahme genutzt wird, automatisch durchgeführt werden. In bevorzugter Ausgestaltung kann die Überwachungsphase automatisch in Messpausen des Bildaufnahmebetriebs, insbesondere bei einer in einer Grundposition befindlicher Patientenliege der Magnetresonanzeinrichtung, und/oder aufgrund eines über eine Kommunikationsverbindung und/oder von einer Bedieneinrichtung erhaltenen Servicesignals gestartet werden. Bei einer Nutzung in Bildaufnahmepausen der Magnetresonanzeinrichtung, z. B. bei einer bestimmten Position der Patientenliege ("Home-Position"), kann auch vorgesehen sein, die zur Überwachung durchzuführende Messung bzw. Messungsabfolge abzubrechen bzw. zu unterbrechen, sobald eine Bildaufnahme gestartet wird. Es ist auch ein manueller Start einer Messung zur Überwachung denkbar, insbesondere durch ein Servicesignal, das lokal oder aber auch entfernt, beispielsweise von einem Servicecenter, erzeugt werden kann.

Besonders bevorzugt ist es im Zusammenhang mit einer Überwachung in Überwachungsphasen, wenn in den Überwachungsphasen, wenigstens teilweise, gezielt lediglich einzelne Komponenten mit Leistung beaufschlagt werden. Es können beispielsweise bestimmte Überwachungsfunktionen als einzelne Datenerfassungvorgänge realisiert werden, bei denen immer nur eine Komponente oder auch eine Komponente pro Zweig des Kühlsystems mit bekannter Leistung beaufschlagt wird und das thermische Verhalten über die Zeit gemessen wird. Dies kann als eine Art "Impulsantwort" verstanden werden. Werden lediglich derartige Datenerfassungsvorgänge genutzt, lassen sich die entsprechenden Zusammenhänge und somit auch die Vergleichsgrößen besonders leicht und punktuell herleiten, somit insbesondere in einer Look-Up-Tabelle oder dergleichen verfügbar machen, wobei insbesondere auch eine solide Vergleichsbasis bei Vergleichen unterschiedlicher Magnetresonanzeinrichtungen und/oder bei der Beobachtung des zeitlichen Verlaufs entsteht.

Bei der Nutzung automatisch gestarteter Überwachungsphasen kann zweckmäßigerweise vorgesehen sein, dass diese nur solange gestartet werden, bis eine erforderliche Datenmenge und/oder Messungshäufigkeit erreicht ist. Beispielsweise kann vorgesehen sein, eine komplette Ermittlung/Datenerfassung, insbesondere als Abfolge mehrerer Datenerfassungsvorgänge, wie oben beschrieben, und gegebenenfalls Auswertung aller Vergleichsergebnisse einmal jeden Tag, einmal jede Woche, einmal jeden Monat oder dergleichen anzufordern. Die Überwachung läuft also automatisch derart ab, dass mindestens eine komplette Datenerfassung in einem vorgegebenen Zeitintervall abgeschlossen ist.

In einer zweckmäßigen Weiterbildung der vorliegenden Erfindung kann vorgesehen sein, dass bei der Auswertung der Vergleichsergebnisse wenigstens eine eine Umgebungsbedingung während der Messung der Messgrößen beschreibende Zusatzgröße berücksichtigt wird. Mithin können weitere Bedingungen, unter denen die Überwachung stattfindet, in die Auswertung der Überwachungsergebnisse einbezogen werden. Während derartige Zusatzgrößen, insbesondere bei einer "inline"-Überwachung, den Zustand weiterer Komponenten betreffen können, der Auswirkungen auf die Betrachtung einer bestimmten Komponente haben kann, umfassen die hier genannten Umgebungsbedingungen auch Umgebungsbedingungen der Magnetresonanzeinrichtung an sich, wobei in einer besonders vorteilhaften Ausgestaltung der vorliegenden Erfindung vorgesehen sein kann, dass als wenigstens eine der wenigstens einen Zusatzgröße eine Wetterbedingung, insbesondere eine Außentemperatur, verwendet wird. Dabei sei darauf hingewiesen, dass Zusatzgrößen, die die Magnetresonanzeinrichtung eventuell nicht selbst liefert, beispielsweise Außentemperaturwerte, auch von externen Einrichtungen abgerufen werden können, beispielsweise aus dem Internet und/oder von kommerziellen Providern, beispielsweise Wetterdatenprovidern. Die Berücksichtigung solcher, insbesondere auf Wetterbedingungen bezogener Zusatzgrößen, ermöglicht beispielsweise die Erkennung von Fehlerursachen, die mit hoher Außentemperatur in Zusammenhang stehen.

Die Auswertung der Vergleichsergebnisse durch das wenigstens eine Maßnahmenkriterium und/oder die nachgelagerte Auswertung kann auf einer Steuereinrichtung der Magnetresonanzeinrichtung und/oder einer zu der Magnetresonanzeinrichtung externen und/oder entfernten, insbesondere einem Hersteller der Magnetresonanzeinrichtung und/oder einem Servicedienstleiter zugeordneten, Recheneinrichtung erfolgen. Dies gilt im Übrigen auch für die Ermittlung der Vergleichsergebnisse selbst, so dass beispielsweise Messdaten der Temperatursensoren, beispielsweise über ein Bussystem und/oder sonstige Kommunikationsverbindungen, zunächst an die Steuereinrichtung der Magnetresonanzeinrichtung und/oder die Recheneinrichtung übertragen werden können, bevor die Messgrößen ermittelt und/oder der Vergleich explizit oder implizit durchgeführt wird. Mithin kann die Auswertung der Eingangsdaten und/oder Messdaten insgesamt auf der Magnetresonanzeinrichtung selbst oder "offline" durch Übermittlung an eine zentrale Recheneinrichtung, beispielsweise einen Server, geschehen. Die Verwendung einer externen, entfernten, insbesondere zentralen Recheneinrichtung, die bevorzugt mehrere Magnetresonanzeinrichtungen hinsichtlich der Überwachung betreut, hat den besonderen Vorteil, dass auch Magnetresonanzeinrichtungen gleichen Typs im Feld miteinander verglichen werden können.

Daher sieht eine allgemein vorteilhafte Ausgestaltung vor, dass als wenigstens eine der wenigstens einen Vergleichsgröße eine Messgröße einer anderen Magnetresonanzeinrichtung verwendet wird. Dabei kann eine andere Magnetresonanzeinrichtung gleichen Typs und/oder gleicher Ausstattung und/oder eine Komponente gleichen Typs und/oder gleicher Ausstattung bei gleichem Kühlsystem herangezogen werden. Auf diese Weise kann insbesondere beobachtet werden, ob eine Kühlleistungsdegradation auf ein allgemeines, insgesamt auftretendes Altern zurückzuführen ist und/oder ein spezielles Problem der betrachteten Magnetresonanzeinrichtung darstellt. Mithin ist der Vergleich der Überwachung von Kühlsystemen verschiedener Magnetresonanzeinrichtungen miteinander einer genaueren Analyse des Zustands des Kühlsystems weiter zuträglich.

Neben dem Verfahren betrifft die Erfindung auch eine Magnetresonanzeinrichtung, aufweisend ein Kühlsystem zur Kühlung mehrerer zu kühlender Komponenten, wenigstens einem Teil der Komponenten zuordenbare Temperatursensoren und eine zur Durchführung eines erfindungsgemäßen Verfahrens ausgebildete Steuereinrichtung. Sämtliche Ausführungen bezüglich des erfindungsgemäßen Verfahrens lassen sich analog auf die erfindungsgemäße Magnetresonanzeinrichtung übertragen, mit welcher mithin ebenso die bereits genannten Vorteile erhalten werden können.

Ein erfindungsgemäßes Computerprogramm ist beispielsweise direkt in einen Speicher einer Steuereinrichtung einer Magnetresonanzeinrichtung ladbar und weist Programmmittel auf, um die Schritte eines erfindungsgemäßen Verfahrens auszuführen, wenn das Computerprogramm in der Steuereinrichtung der erfindungsgemäßen Magnetresonanzeinrichtung ausgeführt wird. Das Computerprogramm kann auf einem erfindungsgemäßen elektronisch lesbaren Datenträger gespeichert sein, welcher mithin darauf gespeicherte elektronisch lesbare Steuerinformationen umfasst, welche zumindest ein erfindungsgemäßes Computerprogramm umfassen und derart ausgestaltet sind, dass sie bei Verwendung des Datenträgers in einer Steuereinrichtung einer erfindungsgemäßen Magnetresonanzeinrichtung ein erfindungsgemäßes Verfahren durchführen. Bei dem Datenträger kann es sich insbesondere um einen nicht transienten Datenträger, beispielsweise eine CD-ROM, handeln.

Die Durchführung des Computerprogramms bzw. des erfindungsgemäßen Verfahrens durch die Steuereinrichtung kann dabei insbesondere Ansteuerungen anderer Funktionsmittel der Magnetresonanzeinrichtung umfassen, insbesondere dann, wenn die Überwachung der Funktion des Kühlsystems in Überwachungsphasen stattfinden soll, in denen gezielte Datenerfassungsvorgänge vorgesehen sind.

Weitere Vorteile und Einzelheiten der vorliegenden Erfindung ergeben sich aus den im Folgenden beschriebenen Ausführungsbeispielen sowie anhand der Zeichnungen. Dabei zeigen:
- Fig. 1: eine Prinzipskizze einer erfindungsgemäßen Magnetresonanzeinrichtung,
- Fig. 2: einen Ablaufplan eines ersten Ausführungsbeispiels des erfindungsgemäßen Verfahrens und
- Fig. 3: einen Ablaufplan eines zweiten Ausführungsbeispiels des erfindungsgemäßen Verfahrens.

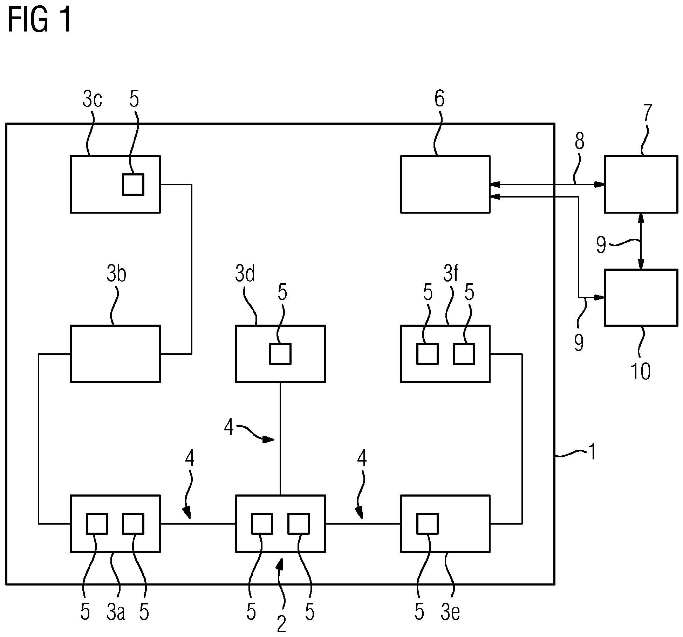

Fig. 1 zeigt eine Prinzipskizze einer erfindungsgemäßen Magnetresonanzeinrichtung 1, wobei der Einfachheit halber nur für die vorliegende Erfindung relevante Komponenten gezeigt sind. Weitere Komponenten wie ein supraleitender Grundfeldmagnet, eine diesem zugeordnete Kühleinrichtung, diverse Spulenanordnungen und dergleichen sind selbstverständlich, wie im Stand der Technik bekannt, vorhanden.

Die Magnetresonanzeinrichtung 1 umfasst ein vorliegend Wasser als Kühlmittel nutzendes Kühlsystem 2, welches zur Kühlung zu kühlender Komponenten 3a bis 3f in verschiedenen Kühlzweigen 4, in denen Komponenten 3a bis 3f seriell gekühlt werden können, verwendet wird. Das Kühlmittel wird dabei durch Kühlleitungen geführt, die insbesondere auch durch die Komponenten 3a bis 3f verlaufen können. Entsprechende Rücktransportleitungen sind der Übersichtlichkeit halber nicht gezeigt, aber selbstverständlich vorhanden.

An verschiedenen der Komponenten 3a bis 3f bzw. diesen zugeordnet sind als Teil der Magnetresonanzeinrichtung 1 Temperatursensoren 5 vorgesehen, welche als Messdaten entsprechende Temperaturwerte liefern. Diese Temperaturwerte können, gegebenenfalls auch nur zeitweise, wie dargelegt werden wird, verschiedenen Komponenten 3a bis 3f zugeordnet werden.

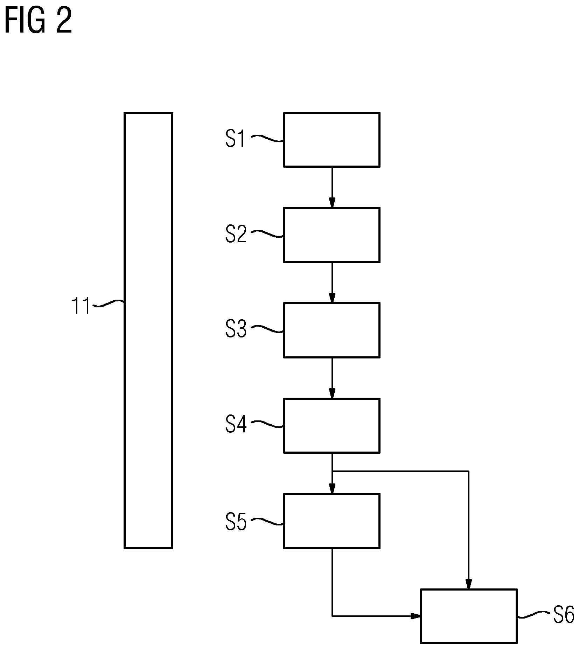

Es sei angemerkt, dass es grundsätzlich denkbar, jedoch weniger bevorzugt ist, auch dediziert für das Kühlsystem 2 vorgesehene Temperatursensoren und/oder Flusssensoren zu verwenden, wobei vorliegend in Fig. 2 optionale Temperatursensoren 5 an Kühlsystemteilen wenigstens angedeutet sind. Derartige Kühlsystem-Temperatursensoren 5 können beispielsweise für die Kühlzweige 4 die Temperatur ausfließenden oder zurückkehrenden Kühlmittels überwachen.

Die Magnetresonanzeinrichtung 1 umfasst ferner eine Steuereinrichtung 6, die zur Durchführung des erfindungsgemäßen Verfahrens ausgebildet ist. Das bedeutet, eine Überwachung der Funktion des Kühlsystems 2 kann durch die Steuereinrichtung 6 anhand der Messdaten der Temperatursensoren 5, die der Steuereinrichtung 6 bereitgestellt werden, erfolgen. In einer Variante, bei der die Magnetresonanzeinrichtung nicht nach Anspruch 18 ausgebildet ist und somit nicht in den Schutzumfang des Anspruchs 18 fällt, erfolgt die Überwachung der Funktion des Kühlsystems 2 auch zumindest teilweise auf einer zu der Magnetresonanzeinrichtung 1 externen, entfernt zu dieser angeordneten, zentralen Recheneinrichtung 7, beispielsweise einem Server, der über eine entsprechende Kommunikationsverbindung 8, welche auch das Internet umfassen kann, mit der Steuereinrichtung 6 kommunizieren kann, um entsprechend benötigte Daten auszutauschen. In einer weiteren Variante, bei der die Magnetresonanzeinrichtung ebenfalls nicht nach Anspruch 18 ausgebildet ist und somit ebenfalls nicht in den Schutzumfang des Anspruchs 18 fällt, ist auch eine im Wesentlichen komplette Durchführung der Überwachung seitens der zentralen Recheneinrichtung 7 denkbar, wobei dann beispielsweise die Messdaten der Temperatursensoren 5, Leistungsdaten und dergleichen über die Kommunikationsverbindung 8 an die Recheneinrichtung 7 geliefert werden.

Die Steuereinrichtung 6 und die Recheneinrichtung 7 können zudem über entsprechende Kommunikationsverbindungen 9 mit weiteren Datenquellen 10 kommunizieren, um im Rahmen der Überwachung der Funktion des Kühlsystems 2 genutzte Zusatzgrößen, die nicht durch die Magnetresonanzeinrichtung 1 bestimmt werden können, zu ermitteln, beispielsweise Wetterbedingungen beschreibende Zusatzgrößen wie die Außentemperatur. Messdaten der Temperatursensoren 5 können Komponenten 3a bis 3f zugeordnet werden, wobei hierzu die Temperatursensoren 5 nicht zwangsläufig unmittelbar an der Komponente befestigt sein müssen, dies aber vorgesehen sein kann. Die Komponenten 3a und 3f weisen beispielsweise zwei Temperatursensoren 5 auf, die Temperaturwerte in einem Eintrittsbereich des Kühlmittels und in einem Austrittsbereich des Kühlmittels messen können. Die Komponenten 3c und 3e weisen jeweils einen im Eintrittsbereich messenden Temperatursensor 5 auf, die Komponente 3d nur einen allgemein an der Komponente 3d messenden Temperatursensor 5. Nichtsdestotrotz lassen sich beispielsweise auch für die Komponente 3b Temperaturwerte für den Eintrittsbereich des Kühlmittels und den Austrittsbereich des Kühlmittels bestimmen, nachdem beispielsweise Temperaturwerte des ausgangsseitig angeordneten Temperatursensors 5 der Komponente 3a als Maß für die eintrittsseitige Temperatur der Komponente 3b angesehen werden, was analog für den eintrittsseitigen Temperatursensor 5 der Komponente 3c und den Austrittsbereich der Komponente 3b gilt. Ist die Komponente 3e beispielsweise zur Zeit nicht in Betrieb, findet dort also kein Leistungseintrag statt, kann sogar der dort eintrittsseitig vorgesehene Temperatursensor 5 genutzt werden, um Temperaturwerte für die Komponente 3f zu erhalten, falls die Komponente 3f keinen oder keinen funktionsfähigen Temperatursensor enthalten sollte.

Die Komponenten 3a bis 3f können konkret eine Gradientenspulenanordnung und/oder wenigstens einen Gradientenverstärker und/oder einen Kompressor zum Antrieb eines Kaltkopfes zum Kühlen des supraleitenden Grundfeldmagneten und/oder einen Hochfrequenz-Leistungsverstärker und/oder Recheneinrichtungen und/oder Transformatoren und/oder Netzteile umfassen.

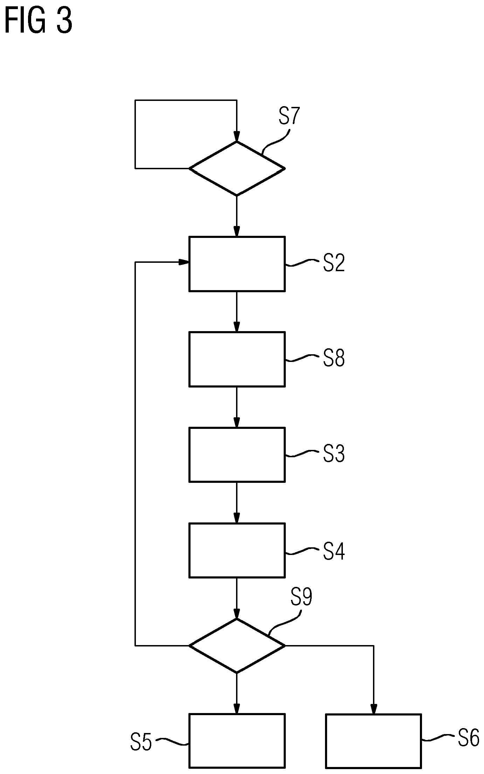

Im Folgenden soll das erfindungsgemäße Verfahren nun in Form zweier konkreter Ausführungsbeispiele erläutert werden, wobei das erste Ausführungsbeispiel gemäß Fig. 2 eine Überwachung der Funktion des Kühlsystems 2 während des Bildaufnahmebetriebs der Magnetresonanzeinrichtung 1 betrifft, das zweite Ausführungsbeispiel gemäß Fig. 3 eine Überwachung in manuell und/oder automatisch startbaren Überwachungsphasen.

Gemäß dem Ausführungsbeispiel der Fig. 2 ist der laufende Bildaufnahmebetrieb durch den Kasten 11 angedeutet. Während des Bildaufnahmebetriebs werden durch Nutzung entsprechender Betriebsparameter der Magnetresonanzeinrichtung 1, insbesondere von Sequenzparametern einer Magnetresonanzsequenz, Leistungseinträge in die Komponenten 3a bis 3f verursacht. Diese Leistungseinträge führen zu einer Erwärmung entsprechender Komponente 3a bis 3f, wobei das Temperaturverhalten der jeweiligen Komponente 3a bis 3f bezüglich dieses Leistungseintrags beurteilt werden soll, um die Funktion des Kühlsystems 2 zu überprüfen.

Die im Folgenden beschriebenen Schritte müssen dabei nicht vollständig in der genannten Reihenfolge ablaufen; es erschließt sich, dass voneinander unabhängige Schritte, insbesondere Ermittlungsschritte, in ihrer Reihenfolge verändert und/oder gleichzeitig ausgeführt werden können.

In einem Schritt S1 werden aus den Betriebsparametern, insbesondere den Sequenzparametern, Leistungsdaten für Komponenten 3a bis 3f ermittelt, in die aufgrund der Betriebsparameter ein Leistungseintrag stattfindet. Vorliegend beschreiben die Leistungsdaten eine eingetragene Leistung sowie die Dauer des Leistungseintrags. Dabei wird ein Leistungsmodell verwendet, mithilfe dessen die Betriebsparameter in die Leistungsdaten umrechenbar sind.

In einem Schritt S2 wird unmittelbar vor Beginn des Leistungseintrags in die entsprechende Komponente 3a bis 3f wenigstens eine Starttemperatur der Komponente 3a bis 3f durch Nutzung der Temperatursensoren 5, wie oben beschrieben, ermittelt.

Unter Nutzung der wenigstens einen Starttemperatur, wobei insbesondere Starttemperaturen für den Eintrittsbereich und den Austrittsbereich eingesetzt werden, wie oben beschrieben, sowie der Leistungsdaten wird in einem Schritt S3 wenigstens eine Vergleichsgröße ermittelt, wozu verschiedene Möglichkeiten denkbar sind. Wenigstens eine der wenigstens einen Vergleichsgrößen soll dabei vorliegend eine maximal zulässige Erwärmung der betrachteten Komponente 3a bis 3f während des Leistungseintrags, wobei gegen die dort entstehende Abwärme das Kühlsystem 2 wirkt, sein. Eine derartige Vergleichsgröße basiert im hier vorliegenden Fall bevorzugt auf einem Temperaturänderungsmodell, nachdem aufgrund der Vielzahl unterschiedlicher Betriebszustände der Magnetresonanzeinrichtung 1, die während des Bildaufnahmebetriebs eintreten können, auch eine Vielzahl von Kombinationen von Starttemperaturen und Leistungsdaten entstehen, für die Vergleichswerte nicht immer in ausreichender Zahl in einer Look-Up-Tabelle und/oder einem Kennfeld vorgehalten werden können. Selbstverständlich kann bei Verwendung einer Look-Up-Tabelle und/oder eines Kennfelds die Grundlage der darin enthaltenen Vergleichsgrößen ebenso das Temperaturänderungsmodell sein, mithin eine Vorberechnung stattgefunden haben. Das Temperaturänderungsmodell, welches das thermische Verhalten der Komponente 3a bis 3f unter Einfluss des Leistungseintrags und einer Sollfunktionalität des Kühlsystems 2 abbildet, kann dabei gegebenenfalls in Form einer mathematischen Formel und/oder einem sonstigen mathematischen Zusammenhang gegeben sein, aber auch zur Ermittlung in Form einer Simulation dienen.

Im Schritt S3 können auch weitere Vergleichsgrößen bereitgestellt werden, beispielsweise in der Vergangenheit bei gleichen Leistungsdaten und gleicher wenigstens einer Starttemperatur mit den Temperatursensoren 5 gemessene Messgrößen. Damit kann dann insbesondere eine zeitliche Veränderung des Kühlverhaltens beobachtet werden. Vergleichsgrößen können ferner Messgrößen vergleichbarer Komponenten 3a bis 3f umfassen, beispielsweise von Leistungsverstärkern für Gradientenspulen anderer Richtung und dergleichen. Schließlich können, insbesondere bei Ausführung seitens der Recheneinrichtung 7, als Vergleichsgrößen auch entsprechende Messgrößen anderer, insbesondere typgleicher, Magnetresonanzeinrichtungen herangezogen werden, um auch einen Vergleich zwischen Magnetresonanzeinrichtungen zu erlauben.

In einem Schritt S4 wird durch Messung eine der Vergleichsgröße entsprechende Messgröße, insbesondere eine eingetreten Temperaturänderung während des Zeitraums des Leistungseintrags und/oder eines sonstigen Zeitraums, durch Messung mit den Temperatursensoren 5 ermittelt.

Es sei noch angemerkt, dass selbstverständlich auch andere Zeiträume betrachtet werden können, beispielsweise ein Nachkühlungszeitraum, der unmittelbar an den Leistungseintrag anschließt, wobei dann als wenigstens eine der wenigstens einen Vergleichsgröße eine minimal zulässige Abkühlung verwendet werden kann.

In Schritten S5 und S6 erfolgt dann die Auswertung durch Vergleich der wenigstens einen Vergleichsgröße mit der Messgröße. Gemäß dem Schritt S5 kann durch unmittelbare Auswertung des Vergleichsergebnisses mittels Maßnahmenkriterien zeitlich unmittelbar folgend überprüft werden, ob Maßnahmen erfordernde Zustände des Kühlsystems 2 vorliegen, beispielsweise ein Fehlerfall, der zu einer veränderten Ansteuerung des Kühlsystems 2 und/oder der Magnetresonanzeinrichtung 1 und/oder zur Ausgabe eines Warnsignals als Maßnahme führen kann.

Auch in einem zeitlich beabstandeten Auswertungsschritt S6 können noch Maßnahmenkriterien überprüft werden, beispielsweise seitens der Recheneinrichtung 7, und/oder es folgen andere Auswertungsmaßnahmen bezüglich der Vergleichsergebnisse. Die Vergleichsergebnisse werden innerhalb der Steuereinrichtung 6 und der Recheneinrichtung 7 protokolliert. Insbesondere wird hierbei auch ein Messgrößenverlauf für die untersuchten Komponenten 3a bis 3f für gleiche Starttemperaturen und gleiche Leistungseinträge gespeichert, um Trends ablesen zu können, die beispielsweise auf langsam verstopfende Kühlmittelleitungen oder dergleichen hinweisen können.

Fig. 3 zeigt ein weiteres, zweites Ausführungsbeispiel des erfindungsgemäßen Verfahrens, in welchem die Überwachung der Funktion des Kühlsystems 2 außerhalb des Bildaufnahmebetriebs in manuell und/oder automatisch zu startenden Überwachungsphasen stattfindet. Dabei wird zunächst in einem Schritt S7 überwacht, ob eine Überwachungsbedingung erfüllt ist, bei manuellem Start einer Überwachungsphase also ein entsprechendes von einer Bedieneinrichtung oder über die Kommunikationsverbindung 8 erhaltenes Servicesignal vorliegt, bei der bevorzugten automatischen Ausführung, ob eine Messpause des Bildaufnahmebetriebs vorliegt, bei der sich die Patientenliege in einer aus einer Patientenaufnahme der Magnetresonanzeinrichtung 1 ausgefahrenen Grundposition ("Home-Position") befindet.

Die Überwachungsphase kann mehrere Datenerfassungsvorgänge umfassen, die insbesondere jeweils einzelne Komponenten 3a bis 3f oder zumindest jeweils nur eine Komponente 3a bis 3f pro Kühlzweig 4 betreffen. Für einen solchen Datenerfassungsvorgang, der durch einen speziellen, vorbekannten, durch vorbekannte Leistungsdaten bestimmten Leistungseintrag in eine einzelne Komponente 3a bis 3f bzw. eine einzelne Komponente 3a bis 3f eines Kühlzweiges 4, gekennzeichnet ist, werden zunächst in einem dem ersten Ausführungsbeispiel entsprechenden Schritt S2 die Starttemperaturen der betroffenen Komponenten 3a bis 3f ermittelt, wiederum durch Messung mit den Temperatursensoren 5. Die Leistungsdaten sind ja bereits bekannt.

In einem Schritt S8 wird die Magnetresonanzeinrichtung 1 durch die Steuereinrichtung 6 so angesteuert, dass der entsprechende durch die Leistungsdaten beschriebene Leistungseintrag, der für diesen Datenerfassungsvorgang vorgesehen ist, in die für diesen Datenerfassungsvorgang betroffenen Komponenten 3a bis 3f erfolgt, andere Komponenten 3a bis 3f jedoch im Wesentlichen unbeeinflusst bleiben.

Der nun folgende (gegebenenfalls aber auch bereits vorher oder nachher durchführbare) Schritt der Ermittlung der wenigstens einen Vergleichsgröße entspricht wiederum dem Schritt S3, wobei es hier aufgrund der fest vorgegebenen Leistungseinträge für die (wenigen) Datenerfassungsvorgänge bevorzugt ist, eine Look-Up-Tabelle zu verwenden, um die wenigstens eine Vergleichsgröße abzurufen.

Aufgrund der Ansteuerung im Schritt S8 lassen sich wie im Schritt S4 wiederum die Messgrößen ermitteln.

In einem Schritt S9 wird dann überprüft, ob noch weitere Datenerfassungsvorgänge durchzuführen sind, wobei in diesem Fall zum nächsten Datenerfassungsvorgang fortgeschritten wird und wiederum zum Schritt S2 verzweigt wird. Sind alle Datenerfassungsvorgänge abgeschlossen, erfolgt in dem ersten Ausführungsbeispiel entsprechenden Schritten S5 und S6 wiederum die Datenauswertung durch Ermittlung der Vergleichsergebnisse, Protokollierung derselben und/oder Auswertung derselben in Maßnahmenkriterien.

Es sei darauf hingewiesen, dass in dem Schritt S7 auch überprüft werden kann, ob alle Datenerfassungsvorgänge innerhalb eines bestimmten Zeitintervalls bereits einmal durchgeführt wurden, so dass mithin alle Datenerfassungsvorgänge einmal pro Tag, einmal pro Woche, einmal pro Monat oder dergleichen durchgeführt werden können. Sind für das vorgegebene Zeitintervall die Datenerfassungsvorgänge alle bereits durchgeführt, muss auch keine Überwachungsphase stattfinden. Ferner ist es denkbar, dann, wenn während einer Überwachungsphase eine Bildaufnahme angefordert wird, die Überwachungsphase zu unterbrechen, bis gemäß der Überwachung im Schritt S7 die Überwachungsbedingung wieder erfüllt ist, so dass dann die Überwachungsphase entsprechend mit den noch verbleibenden Datenerfassungsvorgängen fortgesetzt werden kann.

Bei der Auswertung in den Schritten S5 und S6 können auch Zusatzgrößen, beispielsweise die bereits erwähnte Außentemperatur bzw. allgemein Wetterbedingungen, berücksichtigt werden. Zur konkreten Umsetzung des Verfahrens innerhalb der Steuereinrichtung 6 und/oder der Recheneinrichtung 7 können entsprechende Funktionseinheiten vorgesehen werden, beispielsweise Ermittlungseinheiten für die verschiedenen Größen, Steuereinheiten und dergleichen.

Es sei schließlich noch darauf hingewiesen, dass in bevorzugten Ausführungsbeispielen in wenigstens einen Teil der wenigstens einen Vergleichsgröße auch Ergebnisse einer Kalibrierungsmessung eingehen können bzw. Vergleichsgrößen auch vollständig aufgrund einer solchen Kalibrierungsmessung ermittelt werden können. Eine solche Kalibrierungsmessung findet bevorzugt bei Inbetriebnahme der Magnetresonanzeinrichtung 1 statt.

Obwohl die Erfindung im Detail durch das bevorzugte Ausführungsbeispiel näher illustriert und beschrieben wurde, so ist die Erfindung nicht durch die offenbarten Beispiele eingeschränkt und andere Variationen können vom Fachmann hieraus abgeleitet werden, ohne den Schutzumfang der Erfindung zu verlassen, der durch die Ansprüche definiert wird.

## Patentansprüche

1. Verfahren zur Überwachung der Funktion eines Kühlsystems (2) einer Magnetresonanzeinrichtung (1), die mehrere durch das Kühlsystem (2) gekühlte Komponenten (3a, 3b, 3c, 3d, 3e, 3f) und den Komponenten (3a, 3b, 3c, 3d, 3e, 3f) zumindest teilweise zuordenbare Temperatursensoren (5) aufweist, **dadurch gekennzeichnet, dass** zur Überwachung der Funktion des Kühlsystems (2) bezüglich wenigstens einer der Komponenten (3a, 3b, 3c, 3d, 3e, 3f), in die ein Leistungseintrag erfolgt,
- eine Starttemperatur der Komponente (3a, 3b, 3c, 3d, 3e, 3f) unmittelbar vor Beginn des Leistungseintrags mittels wenigstens eines der Komponente (3a, 3b, 3c, 3d, 3e, 3f) zugeordneten Temperatursensors (5) ermittelt wird,
- aus der Starttemperatur wenigstens eine eine Vergleichstemperaturänderung durch den Leistungseintrag beschreibende Vergleichsgröße ermittelt wird,
- eine durch den Leistungseintrag tatsächlich auftretende Temperaturänderung beschreibende Messgröße mittels des wenigstens einen der Komponente (3a, 3b, 3c, 3d, 3e, 3f) zugeordneten Temperatursensors (5) gemessen wird, und
- die Messgröße mit der Vergleichsgröße verglichen wird, wobei bei Erfüllung eines wenigstens das aktuelle Vergleichsergebnis auswertenden Maßnahmenkriteriums eine dem Maßnahmenkriterium zugeordnete Maßnahme durchgeführt wird und/oder das Vergleichsergebnis durch Abspeicherung für eine spätere Auswertung protokolliert wird.

2. Verfahren nach Anspruch 1, **dadurch gekennzeichnet, dass** den zeitbezogenen Leistungseintrag in die betreffende Komponente (3a, 3b, 3c, 3d, 3e, 3f) beschreibende Leistungsdaten vorliegen und die Vergleichsgröße aus der Starttemperatur und den Leistungsdaten ermittelt wird.

3. Verfahren nach Anspruch 2, **dadurch gekennzeichnet, dass** für wenigstens eine Komponente (3a, 3b, 3c, 3d, 3e, 3f) wenigstens zwei insbesondere unterschiedlichen Orten an der Komponente (3a, 3b, 3c, 3d, 3e, 3f) zugeordnete Starttemperaturen und jeweilige Messgrößen gemessen werden, wobei aus den Starttemperaturen und den Leistungsdaten gemeinsam jeweils die wenigstens zwei entsprechenden Vergleichsgrößen ermittelt werden.

4. Verfahren nach Anspruch 3, **dadurch gekennzeichnet, dass** eine Starttemperatur auf einen Eintrittsbereich von Kühlmittel des Kühlsystems (2) in die Komponente (3a, 3b, 3c, 3d, 3e, 3f) und eine weitere Starttemperatur auf einen Austrittsbereich von Kühlmittel des Kühlsystems (2) aus der Komponente (3a, 3b, 3c, 3d, 3e, 3f) bezogen ist.

5. Verfahren nach Anspruch 4, **dadurch gekennzeichnet, dass** bei einer seriellen Kühlung mehrerer Komponenten (3a, 3b, 3c, 3d, 3e, 3f) die auf den Austrittsbereich bezogene Starttemperatur einer Komponente (3a, 3b, 3c, 3d, 3e, 3f) und/oder eine allgemeine Starttemperatur einer aktuell unbenutzten Komponente (3a, 3b, 3c, 3d, 3e, 3f) als auf den Eintrittsbereich bezogene Starttemperatur einer folgenden Komponente (3a, 3b, 3c, 3d, 3e, 3f) und/oder als auf den Austrittsbereich bezogene Starttemperatur einer vorangehenden Komponente (3a, 3b, 3c, 3d, 3e, 3f) verwendet wird.

6. Verfahren nach einem der vorangehenden Ansprüche, **dadurch gekennzeichnet, dass** sich die Temperaturänderung auf wenigstens einen Zeitraum bezieht, wobei als Zeiträume die Dauer des Leistungseintrags und/oder eine dem Leistungseintrag folgende Nachkühlungsphase verwendet werden.

7. Verfahren nach einem der vorangehenden Ansprüche, **dadurch gekennzeichnet, dass** wenigstens eine der wenigstens einen Vergleichsgröße eine maximal zulässige Erwärmung beschreibt.

8. Verfahren nach Anspruch 7, **dadurch gekennzeichnet, dass** wenigstens eine der wenigstens einen eine maximal zulässige Erwärmung beschreibenden Vergleichsgröße wenigstens teilweise rechnerisch mittels eines Temperaturänderungsmodells der Komponente (3a, 3b, 3c, 3d, 3e, 3f), insbesondere einmalig für die Leistungsdaten und die Starttemperatur, ermittelt wird und/oder aus einem Kennfeld und/oder einer Look-Up-Tabelle abgerufen wird.

9. Verfahren nach Anspruch 7 oder 8, **dadurch gekennzeichnet, dass** wenigstens eine der wenigstens einen eine maximal zulässige Temperaturänderung beschreibenden Vergleichsgröße wenigstens teilweise durch eine Kalibrierungsmessung bei Inbetriebnahme der Magnetresonanzeinrichtung (1) ermittelt wird.

10. Verfahren nach einem der vorangehenden Ansprüche, **dadurch gekennzeichnet, dass** wenigstens eine der wenigstens einen Vergleichsgröße eine in der Vergangenheit gemessene Temperaturänderung und/oder eine eine funktionsgleiche Komponente (3a, 3b, 3c, 3d, 3e, 3f) der Magnetresonanzeinrichtung (1) betreffende Temperaturänderung beschreibt.

11. Verfahren nach Anspruch 10, **dadurch gekennzeichnet, dass** durch zeitliches Auftragen mehrerer in der Vergangenheit für eine überwachte Komponente (3a, 3b, 3c, 3d, 3e, 3f) gemessene Temperaturänderungen beschreibender Vergleichsgrößen und der aktuellen Messgröße ein Temperaturänderungsverlauf gebildet wird, der von wenigstens einem Maßnahmenkriterium ausgewertet wird.

12. Verfahren nach einem der vorangehenden Ansprüche, **dadurch gekennzeichnet, dass** die Überwachung während des Bildaufnahmebetriebs der Magnetresonanzeinrichtung (1) erfolgt, wobei, falls Leistungsdaten verwendet werden, ein Leistungsdaten aus aktuellen Betriebsparametern der Magnetresonanzeinrichtung (1), insbesondere Sequenzparametern einer Magnetresonanzsequenz, ermittelndes Leistungsmodell verwendet wird.

13. Verfahren nach einem der vorangehenden Ansprüche, **dadurch gekennzeichnet, dass** die Überwachung in dedizierten, manuell und/oder automatisch begonnenen Überwachungsphasen erfolgt, in denen die Magnetresonanzeinrichtung (1) mit vorbestimmten Betriebsparametern, wobei insbesondere deren zugehörige Leistungsdaten bekannt sind, betrieben wird.

14. Verfahren nach Anspruch 13, **dadurch gekennzeichnet, dass** die Überwachungsphase automatisch in Messpausen des Bildaufnahmebetriebs, insbesondere bei einer in einer Grundposition befindlichen Patientenliege der Magnetresonanzeinrichtung (1), und/oder aufgrund eines über eine Kommunikationsverbindung und/oder von einer Bedieneinrichtung erhaltenen Servicesignals gestartet wird.

15. Verfahren nach Anspruch 13 oder 14, **dadurch gekennzeichnet, dass** in den Überwachungsphasen, wenigstens teilweise, gezielt lediglich einzelne Komponenten (3a, 3b, 3c, 3d, 3e, 3f) mit Leistung beaufschlagt werden.

16. Verfahren nach einem der vorangehenden Ansprüche, **dadurch gekennzeichnet, dass** bei der Auswertung der Vergleichsergebnisse wenigstens eine Umgebungsbedingungen während der Messung der Messgrößen beschreibende Zusatzgröße berücksichtigt wird.

17. Verfahren nach einem der vorangehenden Ansprüche, **dadurch gekennzeichnet, dass** die Auswertung der Vergleichsergebnisse durch das wenigstens eine Maßnahmenkriterium und/oder die nachgelagerte Auswertung auf einer Steuereinrichtung (6) der Magnetresonanzeinrichtung (1) und/oder einer zu der Magnetresonanzeinrichtung (1) externen und/oder entfernten, insbesondere einem Hersteller der Magnetresonanzeinrichtung (1) und/oder einem Servicedienstleister zugeordneten Recheneinrichtung (7) erfolgt.

18. Magnetresonanzeinrichtung (1), aufweisend ein Kühlsystem, das (2) zur Kühlung mehrerer zu kühlender Komponenten (3a, 3b, 3c, 3d, 3e, 3f) eingerichtet ist, wenigstens einem Teil der Komponenten (3a, 3b, 3c, 3d, 3e, 3f) zuordenbaren Temperatursensoren (5) und eine zur Durchführung eines Verfahrens nach einem der vorangehenden Ansprüche ausgebildete Steuereinrichtung (6).

19. Computerprogramm, welches die Schritte eines Verfahrens nach einem der Ansprüche 1 bis 17 durchführt, wenn es auf der Steuereinrichtung (6) der Magnetresonanzeinrichtung (1) nach Anspruch 18 ausgeführt wird.

20. Elektronisch lesbarer Datenträger, auf dem ein Computerprogramm nach Anspruch 19 gespeichert ist.

## Claims

1. Method for monitoring the function of a cooling system (2) of a magnetic resonance device (1), having a plurality of components (3a, 3b, 3c, 3d, 3e, 3f) cooled by the cooling system (2) and temperature sensors (5) that can be at least partially associated with the components (3a, 3b, 3c, 3d, 3e, 3f), **characterised in that** for monitoring the function of the cooling system (2) in respect of at least one of the components (3a, 3b, 3c, 3d, 3e, 3f), in which a power input occurs,
- a start temperature of the components (3a, 3b, 3c, 3d, 3e, 3f) is determined immediately before the start of the power input by means of at least one temperature sensor (5) associated with the components (3a, 3b, 3c, 3d, 3e, 3f),
- at least one comparison variable that describes a reference temperature change due to the power input is determined from the start temperature,
- a measured variable that describes temperature change that actually occurs due to the power input is measured by means of the at least one temperature sensor (5) associated with the component (3a, 3b, 3c, 3d, 3e, 3f), and
- the measured variable is compared with the comparison variable, wherein when an action criterion that evaluates at least the current comparison result is fulfilled, an action associated with the action criterion is carried out and/or the comparison result is logged by storage for subsequent evaluation.

2. Method according to claim 1, **characterised in that** power data that describes the time-based power input into the relevant components (3a, 3b, 3c, 3d, 3e, 3f) exists and the comparison variable is determined from the start temperature and the power data.

3. Method according to claim 2, **characterised in that** for at least one component (3a, 3b, 3c, 3d, 3e, 3f), at least two start temperatures associated in particular with different locations on the components (3a, 3b, 3c, 3d, 3e, 3f) and respective measured variables are measured, wherein in each case the at least two corresponding comparison variables are jointly determined from the start temperatures and the power data.

4. Method according to claim 3, **characterised in that** a start temperature is based on an entrance region of coolant of the cooling system (2) into the components (3a, 3b, 3c, 3d, 3e, 3f) and a further start temperature is based on an exit region of coolant of the cooling system (2) from the components (3a, 3b, 3c, 3d, 3e, 3f).

5. Method according to claim 4, **characterized in that** with serial cooling of a plurality of components (3a, 3b, 3c, 3d, 3e, 3f) the start temperature, based on the exit region, of a component (3a, 3b, 3c, 3d, 3e, 3f) and/or a general start temperature of a currently unused component (3a, 3b, 3c, 3d, 3e, 3f) is used as the start temperature, based on the entry region, of a subsequent component (3a, 3b, 3c, 3d, 3e, 3f) and/or as the start temperature, based on the exit region, of a preceding component (3a, 3b, 3c, 3d, 3e, 3f).

6. Method according to one of the preceding claims, **characterised in that** the temperature change is based on at least one period, wherein the duration of the power input and/or a post-cooling phase that follows the power input are used as the periods.

7. Method according to one of the preceding claims, **characterised in that** at least one of the at least one comparison variables describes a maximum permissible temperature increase.

8. Method according to claim 7, **characterised in that** at least one of the at least one comparison variables that describes a maximum permissible temperature increase is determined at least partially by way of calculation by means of a temperature change model of the components (3a, 3b, 3c, 3d, 3e, 3f), in particular once for the power data and the start temperature, and/or is retrieved from a performance map and/or a lookup table.

9. Method according to claim 7 or 8, **characterised in that** at least one of the at least one comparison variables that describes a maximum permissible temperature change is determined at least partially by a calibration measurement during startup of the magnetic resonance device (1).

10. Method according to one of the preceding claims, **characterised in that** at least one of the at least one comparison variables describes a temperature change measured in the past and/or a temperature change that relates to a component (3a, 3b, 3c, 3d, 3e, 3f) of the magnetic resonance device (1) having the same function.

11. Method according to claim 10, **characterised in that** by plotting over time a plurality of comparison variables that describe changes in temperature measured in the past for a monitored component (3a, 3b, 3c, 3d, 3e, 3f) and the current measured variable, a temperature change characteristic is formed, which is evaluated by at least one action criterion.

12. Method according to one of the preceding claims, **characterised in that** monitoring takes place during image acquisition operation of the magnetic resonance device (1), wherein, if power data is used, a power model that determines power data from current operating parameters of the magnetic resonance device (1), in particular sequence parameters of a magnetic resonance sequence, is used.

13. Method according to one of the preceding claims, **characterised in that** monitoring takes place in dedicated monitoring phases, begun manually and/or automatically, in which the magnetic resonance device (1) is operated with predetermined operating parameters, wherein in particular their associated power data is known.

14. Method according to claim 13, **characterised in that** the monitoring phase is automatically started in scanning breaks of image acquisition operation, in particular with a couch of the magnetic resonance device (1) located in a home position, and/or owing to a service signal obtained by way of a communications link and/or from an operator control.

15. Method according to claim 13 or 14, **characterised in that** in the monitoring phases, at least partially, only individual components (3a, 3b, 3c, 3d, 3e, 3f) are purposefully subjected to power.

16. Method according to one of the preceding claims, **characterised in that** during evaluation of the comparison results at least one additional variable that describes ambient conditions during measurement of the measured variables is considered.

17. Method according to one of the preceding claims, **characterised in that** the comparison results are evaluated by way of the at least one action criterion and/or the subsequent evaluation on a control device (6) of the magnetic resonance device (1) and/or an arithmetic device (7) external to and/or remote from the magnetic resonance device (1), in particular an arithmetic device associated with a manufacturer of the magnetic resonance device (1) and/or a service provider.

18. Magnetic resonance device (1), having a cooling system (2) which is designed to cool a plurality of components (3a, 3b, 3c, 3d, 3e, 3f) to be cooled, temperature sensors (5) that can be associated with at least some of the components (3a, 3b, 3c, 3d, 3e, 3f) and a control device (6) designed for carrying out a method according to one of the preceding claims.

19. Computer program, which carries out the steps of a method according to one of claims 1 to 17 when it is run on the control device (6) of the magnetic resonance device (1) according to claim 18.

20. Electronically readable data carrier on which a computer program according to claim 19 is stored.

## Revendications

1. Procédé de contrôle du fonctionnement d'un système (2) de refroidissement d'un dispositif (1) à résonnance magnétique, qui a plusieurs composants (3a, 3b, 3c, 3d, 3e, 3f) refroidis par le système (2) de refroidissement et des sondes (5) de température pouvant être associées au moins en partie aux composants (3a, 3b, 3c, 3d, 3e, 3f), **caractérisé en ce que**, pour contrôler le fonctionnement du système (2) de refroidissement en ce qui concerne au moins l'un des composants (3a, 3b, 3c, 3d, 3e, 3f), dans lequel a lieu un apport de puissance,
- on détermine une température initiale des composants (3a, 3b, 3c, 3d, 3e, 3f) juste avant le début de l'apport de puissance au moyen d'au moins une sonde (5) de température associée aux composants (3a, 3b, 3c, 3d, 3e, 3f),
- à partir de la température initiale, on détermine au moins une grandeur de comparaison décrivant une variation de température de comparaison par l'apport de puissance,
- on mesure au moyen de la au moins une sonde (5) de température associée aux composants (3a, 3b, 3c, 3d, 3e, 3f) une grandeur de mesure décrivant la variation de température se produisant réellement par l'apport de puissance et
- on compare la grandeur de mesure à la grandeur de comparaison, dans lequel, lorsqu'un critère de mesure exploitant au moins le résultat de la comparaison en cours est satisfait, on prend une mesure associée au critère de mesure et/ou on consigne le résultat de la comparaison par mise en mémoire pour une exploitation ultérieure.

2. Procédé suivant la revendication 1, **caractérisé en ce qu'**il y a des données de puissance décrivant l'apport de puissance rapporté au temps dans les composants (3a, 3b, 3c, 3d, 3e, 3f) concernés et on détermine la grandeur de comparaison à partir de la température initiale et des données de puissance.

3. Procédé suivant la revendication 2, **caractérisé en ce que** pour au moins un composant (3a, 3b, 3c, 3d, 3e, 3f) on mesure des températures initiales, associées à au moins deux emplacements notamment différents des composants (3a, 3b, 3c, 3d, 3e, 3f) et des grandeurs de mesure respectives, dans lequel on détermine conjointement respectivement les au moins deux grandeurs de comparaison correspondantes à partir des températures initiales et des données de puissance.

4. Procédé suivant la revendication 3, **caractérisé en ce qu'**une température initiale se rapporte à une partie d'entrée de fluide de refroidissement du système (2) de refroidissement dans les composants (3a, 3b, 3c, 3d, 3e, 3f) et une autre température initiale à une partie de sortie du fluide de refroidissement du système (2) de refroidissement des composants (3a, 3b, 3c, 3d, 3e, 3f).

5. Procédé suivant la revendication 4, **caractérisé en ce que**, lors d'un refroidissement en série de plusieurs composants (3a, 3b, 3c, 3d, 3e, 3f), on utilise la température initiale, rapportée à la partie de sortie, d'un composant (3a, 3b, 3c, 3d, 3e, 3f) et/ou une température initiale générale d'un composant (3a, 3b, 3c, 3d, 3e, 3f) inutilisé présentement comme température initiale, rapportée à la partie d'entrée, d'un composant (3a, 3b, 3c, 3d, 3e, 3f) et/ou comme température initiale, rapportée à la partie de sortie, d'un composant (3a, 3b, 3c, 3d, 3e, 3f) précédent.

6. Procédé suivant l'une des revendications précédentes, **caractérisé en ce que** la variation de température se rapporte à au moins un laps de temps, dans lequel on utilise comme laps de temps les durées de l'apport de puissance et/ou une phase de post-refroidissement suivant l'apport de puissance.

7. Procédé suivant l'une des revendications précédentes, **caractérisé en ce que** au moins l'une des au moins grandeur de comparaison décrit un échauffement admissible maximum.

8. Procédé suivant la revendication 7, **caractérisé en ce que** l'on détermine au moins l'une des grandeurs de comparaison décrivant au moins un échauffement admissible maximum au moins en partie par le calcul au moyen d'un modèle de variation de température des composants (3a, 3b, 3c, 3d, 3e, 3f), notamment une fois pour les données de puissance et la température initiale et/ou on la prend dans une courbe caractéristique et/ou dans une table de consultation.

9. Procédé suivant la revendication 7 ou 8, **caractérisé en ce que** l'on détermine au moins l'une des grandeurs de comparaison décrivant au moins une variation de température admissible maximum, au moins en partie par une mesure d'étalonnage lors de la mise en service du dispositif (1) à résonnance magnétique.

10. Procédé suivant l'une des revendications précédentes, **caractérisé en ce qu'**au moins l'une des au moins une grandeur de comparaison décrit une variation de température mesurée dans le passé et/ou une variation de température concernant un composant (3a, 3b, 3c, 3d, 3e, 3f) de même fonction du dispositif (1) à résonnance magnétique.

11. Procédé suivant la revendication 10, **caractérisé en ce que** l'on forme en portant en fonction du temps plusieurs variations de température mesurées dans le passé pour un composant(3a, 3b, 3c, 3d, 3e, 3f) contrôlé et la grandeur de mesure en cours, une courbe de variation de température, que l'on exploite par au moins un critère de mesure.

12. Procédé suivant l'une des revendications précédentes, **caractérisé en ce que** l'on effectue le contrôle pendant le fonctionnement d'enregistrement d'image du dispositif (1) à résonnance magnétique, dans lequel, si l'on utilise les données de puissance, on utilise un modèle de puissance déterminant les données de puissance à partir de paramètres de fonctionnement en cours du dispositif (1) à résonnance magnétique, notamment de paramètres d'une séquence de résonnance magnétique.

13. Procédé suivant l'une des revendications précédentes, **caractérisé en ce que** l'on effectue le contrôle, de manière dédiée, manuellement et où, en des phases de contrôle commencées automatiquement, dans lesquelles on fait fonctionner le dispositif (1) à résonnance magnétique avec des paramètres de fonctionnement définies à l'avance, dans lequel notamment ses propres données de puissance sont connues.

14. Procédé suivant la revendication 13, **caractérisé en ce que** l'on fait commencer la phase de contrôle automatiquement dans des pauses de mesure du fonctionnement en enregistrement d'images, notamment alors que la couchette de patient du dispositif (1) à résonnance magnétique se trouve dans une position de base et/ou sur la base d'un signal de service obtenu par une liaison de communication et/ou par un dispositif de commande.

15. Procédé suivant la revendication 13 ou 14, **caractérisé en ce que**, dans les phases de contrôle, on alimente en puissance, au moins en partie, de manière ciblée seulement des composants (3a, 3b, 3c, 3d, 3e, 3f) individuels.

16. Procédé suivant l'une des revendications précédentes, **caractérisé en ce que**, lors de l'exploitation des résultats de la comparaison, on prend en compte au moins une grandeur supplémentaire décrivant des conditions ambiantes pendant la mesure des grandeurs de mesure.

17. Procédé suivant l'une des revendications précédentes, **caractérisé en ce que** l'on effectue l'exploitation des résultats de la comparaison par le au moins un critère de mesure et/ou l'exploitation en aval sur un dispositif (6) de commande du dispositif (1) à résonnance magnétique et/ou un dispositif (7) informatique associé extérieurement et/ou à distance du dispositif (1) à résonnance magnétique, notamment à un fabricant du dispositif (1) à résonnance magnétique et/ou à un prestataire de service.

18. Dispositif (1) à résonnance magnétique comportant un système (2) de refroidissement, qui est conçu pour le refroidissement de plusieurs composants (3a, 3b, 3c, 3d, 3e, 3f) à refroidir, des sondes (5) de température pouvant être associées à au moins une partie des composants (3a, 3b, 3c, 3d, 3e, 3f) et un dispositif (6) de commande constitué pour effectuer un procédé suivant l'une des revendications précédentes.

19. Programme d'ordinateur qui effectue les stades d'un procédé suivant l'une des revendications 1 à 17, lorsqu'il est effectué sur le dispositif (6) de commande du dispositif (1) à résonnance magnétique suivant la revendication 18.

20. Support de données déchiffrable électroniquement, sur lequel est mémorisé un programme d'ordinateur suivant la revendication 19.
